# EUROPÄISCHE PATENTSCHRIFT

(11) **EP 0 572 825 B1**
(45) Veröffentlichungstag und Bekanntmachung des Hinweises auf die Patenterteilung: **11.12.1996**
(21) Anmeldenummer: 93107686.3
(22) Anmeldetag: 11.05.1993
(51) Int. Cl.: H01B 17/28, H01B 5/06

(54) **Filtergehäuse für ein elektrisches, kapazitives Durchführungsfilter**
Housing for electrical capacitive filter
Cage pour filtre électrique capacitif

(30) Priorität: 02.06.1992 DE 4218171
(43) Veröffentlichungstag der Anmeldung: 08.12.1993
(73) Patentinhaber: SIEMENS MATSUSHITA COMPONENTS GmbH & CO KG, 81541 München (DE)
(72) Erfinder: Berg, Ludwig, W-7920 Heidenheim (DE); Utner, Ferdinand, W-8400 Regensburg (DE)
(74) Vertreter: Fuchs, Franz-Josef, Dr.-Ing.

(56) Entgegenhaltungen:
- EP-A- 0 287 349
- CH-A- 564 831
- DD-A- 243 134
- DD-A- 292 989
- DE-A- 2 228 145
- DE-A- 3 308 332
- US-A- 4 699 590

## Beschreibung

Die Erfindung betrifft ein Filtergehäuse für ein elektrisches Durchführungsfilter mit einem metallischen rohr-oder quaderförmigen Gehäusekörper, der beidseitig mit je einem Gehäuseabschluß aus einem isolierenden Material verschlossen ist, und das einen als Durchführungsleiter dienenden Metallbolzen besitzt.

Bei diesen bekannten Durchführungsfiltern (s. z.B. Siemens Matsushita Components: EMC Bauelemente, Datenbuch 1992/1993, S. 98 - 100) wird das Metallgehäuse an beiden Enden mit metallisierenden Keramikrohren oder -scheiben und/oder Druck glasdurchführungen verschlossen. Die Keramiken / Glasdurchführungen sind sowohl mit dem Metallgehäuse als auch mit dem Durchführungsleiter dicht gelötet. Diese Bauweise ist sowohl von den Einzelteilen als auch von den Zusammenbaukosten (mehrfaches Löten) sehr aufwendig bzw. teuer und oft mit hohem Ausschuß belastet.

Vergossene Bauweisen eignen sich vor allem bei größeren Bauformen wegen der unterschiedlichen Ausdehnungskoeffizienten von Harz und Metall nicht und sind auch für den Einsatz bei Durchführungsfiltern mit imprägnierten Kondensatorwickeln nicht geeignet.

Aus der DE-A 33 08 332 ist eine Durchführung bekannt, bei der ein elektrischer Leiterbolzen von einem elektrisch isolierenden Gießharzblock umfaßt ist. Der Gießharzblock ist in einer Metallhülse angeordnet, wobei zur Abdichtung zwischen Gießharzblock und Metallhülse ein O-Ring dient.

Aus der DD-A-292-989 ist eine Isolierdurchführung bekannt, bei der in einem Spaltraum zwischen Isolierkörper und Strombahn ein Dichtring angeordnet ist. Der Dichtring dient beim nacheinander vorzunehmenden Vergießen des Spaltraumes als abdichtendes Element gegenüber dem von jeweils einer Seite einzugießenden Duromerharz.

Aufgabe der Erfindung ist es, ein Filtergehäuse der eingangs angegebenen Art anzugeben, das auch bei größeren Abmessungen eine hohe Dichtigkeit (geringe Leckrate) gewährleistet, sowohl für Bauformen mit trockenen als auch imprägnierten Kondensatorwickeln geeignet und wesentlich kostengünstiger zu fertigen ist.

Diese Aufgabe wird erfindungsgemäß dadurch gelöst, daß die Gehäuseanschlüsse gegenüber dem Metallbolzen und/oder dem Gehäusekörper jeweils mit zumindest einem Elastomer-Dichtring abgschlossen sind, und daß zumindest ein Gehäuseabschluß mit dem Gehäuskörper verklebt ist.

Zweckmäßige Ausgestaltungen sind in den Unteransprüchen angeführt.

Die Erfindung wird anhand der folgenden Ausführungsbeispiele erläutert.

In der dazugehörigen Zeichnunng zeigen
- FIG 1: ein Durchführungsfilter, das nur mit Dichtringen abgeschlossen ist und
- FIG 2: ein Durchführungsfilter mit verklebtem Gehäuseabschluß.

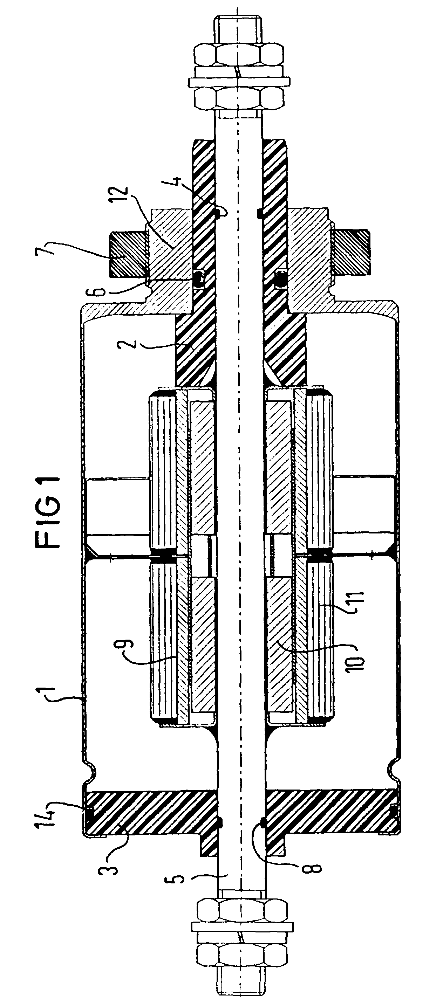

In FIG 1 ist ein Durchführungsfilter dargestellt, das in ein metallisches, rohrförmiges Gehäuse 1 eingebaut ist. Das Gehäuse 1 besitzt zwei Gehäuseabschlüsse 2, 3 aus Kunststoff.

Durch das Gehäuse 1 erstreckt sich der als Durchführungsleiter dienende Metallbolzen 5 mit Schraubanschlüssen zum Anbringen der elektrischen Verbindungen.

Im Gehäuse 1 ist die Filterbaugruppe 9 auf dem Durchführungsbolzen 9 angeordnet. Die Filterbaugruppe 9 besteht aus koaxial zum Durchführungsleiter 5 angeordneten Ferritkernen 10 und trockenen bzw. imprägnierten Kondensatorwickeln 11.

Zum Anschrauben in der Wandung eines geschirmten Raumes besitzt des Gehäuse 1 ferner einen Gewindesockel 12 auf dem eine Mutter 7 angeordnet ist.

Zur Abdichtung zwischen Gehäuse 1 bzw. Durchführungsleiter 5 einerseits und den Gehäuseabschlüssen 2, 3 dienen Elastomerdichtringe 4, 6, 8 und 14 mit rundem oder rechteckigem Querschnitt. Das Material der Dichtringe richtet sich nach den Einsatztemperaturen bzw. einer Chemikalienresistenz und besteht beispielsweise aus EPDM (Ethylen-Propylen-Dienkautschuk), NBR (Nitril-Butadien-Kautschuk), Silicon bzw. PTFE (Polytetrafluorethylen) EK.

Das in der FIG 1 dargestellte Durchführungsfilter läßt sich in einfacher Weise montieren und abdichten, indem die einzelnen Bauteile zusammengesteckt und der Gehäuserand über den Gehäuseabschluß 3 umgebördelt wird. Die Herstellungskosten können mit der dargestellten Ausführungsform eines Filtergehäuses wesentlich, d. h. um ca. die Hälfte, gesenkt werden.

Es ist möglich, um eine Belastung der Einbauten 9 und deren Lötstellen durch axiale Belastung des Durchführungsbolzens 5 auszuschalten, an den Gehäuseabschlüssen 2, 3 entweder innen oder außen Je einen Sicherungsring anzuordnen.

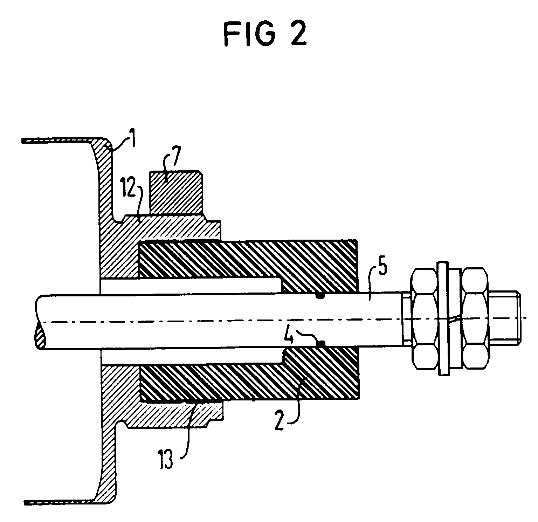

In der FIG 2 ist eine weitere Ausführungsform dargestellt, die einen rationellen Einbau eines Durchführungsfilters in ein Filtergehäuse gestattet. Hier ist der eine Gehäuseabschluß 2 gegenüber dem Gehäusekörper 1 durch einen Kleber 13 abgedichtet. Zur Abdichtung zwischen Gehäuseabschluß 2 und Durchführungsbolzen 5 dient der Elastomerdichtring 4.

Neben den in den Figuren dargestellten Ausführungsbeispielen, bei denen die Gehäuseabschlüsse aus Kunststoff bestehen, ist es auch möglich, Gehäuseabschlüsse aus Keramik zu verwenden, wenn dies aus anwendungstechnischen Gründen (Temperatur, Feuchtigkeit, chemische Beständigkeit usw.) erforderlich ist.

## Patentansprüche

1. Filtergehäuse für ein elektrisches Durchführungsfilter mit einem metallischen rohr- oder quaderförmigem Gehäusekörper (1), der beidseitig mit je einem Gehäuseabschluß (2, 3) aus einem isolierenden Material verschlossen ist, und das einen als Durchführungsleiter dienenden Metallbolzen (5) besitzt,
**dadurch gekennzeichnet,**
daß die Gehäuseabschlüsse (2, 3) gegenüber dem Metallbolzen (5) und/oder dem Gehäusekörper (1) jeweils mit zumindest einem Elastomer-Dichtring (4, 6, 8, 14) abgeschlosen sind, und daß zumindest ein Gehäuseabschluß (2) mit dem Gehäusekörper (1) verklebt ist.

2. Filtergehäuse nach Anspruch 1,
**dadurch gekennzeichnet,**
daß die Gehäuseabschlüsse (2, 3) aus Kunststoff bestehen.

3. Filtergehäuse nach Anspruch 1,
**dadurch gekennzeichnet,**
daß die Gehäuseabschlüsse (2, 3) aus Keramik bestehen.

## Claims

1. Filter housing for an electrical lead-through filter having a metallic tubular or cuboidal housing body (1), which is closed on both sides by in each case a housing termination (2, 3) made of an insulating material, and which housing has a metal bolt (5) serving as a lead-through conductor, characterized in that the housing terminations (2, 3) are terminated with respect to the metal bolt (5) and/or the housing body (1) in each case by at least one elastomer sealing ring (4, 6, 8, 14), and in that at least one housing termination (2) is adhesively bonded to the housing body (1).

2. Filter housing according to Claim 1, characterized in that the housing terminations (2, 3) consist of plastic.

3. Filter housing according to Claim 1, characterized in that the housing terminations (2, 3) consist of ceramic.

## Revendications

1. Boîtier de filtre pour un filtre de traversée électrique, ayant un corps (1) de boîtier métallique tubulaire ou parallélipipédique qui est fermé de chaque côté par une fermeture (2, 3) de boîtier en un matériau isolant, et ayant un axe (5) métallique servant de conducteur de traversée, caractérisé en ce que les fermetures (2, 3) de boîtier sont rendues étanches par rapport à l'axe (5) métallique et/ou au corps (1) du boîtier chacune par au moins un joint (4, 6, 8, 14) d'étanchéité en un élastomère, et en ce qu'au moins une fermeture (2) du boîtier est collée au corps (1) du boîtier.

2. Boîtier de filtre suivant la revendication 1, caractérisé en ce que les fermetures (2, 3) du boîtier sont en matière plastique.

3. Boîtier de filtre suivant la revendication 1, caractérisé en ce que les fermetures (2, 3) du boîtier sont en céramique.
